# FASCICULE DE BREVET EUROPEEN

(11) **EP 2 232 597 B1**
(45) Date de publication et mention de la délivrance du brevet: **17.09.2014**
(21) Numéro de dépôt: 08868594.6
(22) Date de dépôt: 11.12.2008
(51) Int. Cl.: H01L 37/02, H01L 41/317, H01L 41/45

(54) **PROCEDE DE FABRICATION DE CAPTEURS A COUCHE DE CO-POLYMERE P(VDF-TRFE) ET CAPTEUR CORRESPONDANT**
VERFAHREN ZUR HERSTELLUNG VON P(VDF-TRFE)-COPOLYMERSCHICHT-SENSOREN UND ENTSPRECHENDER SENSOR
METHOD FOR MAKING P(VDF-TRFE) COPOLYMER LAYER SENSORS, AND CORRESPONDING SENSOR

(30) Priorité: 21.12.2007 FR 0709031
(43) Date de publication de la demande: 29.09.2010
(73) Titulaire: E2V Semiconductors, 38120 Saint Egrève (FR)
(72) Inventeur: FRITSCH, Lionel, F-38960 St Etienne De Crossey (FR); GIBERT, Philippe, F-38960 St Etienne De Crossey (FR); VACHER, Claire, F-83150 La Valette Du Var (FR)
(74) Mandataire: Guérin, Michel
(86) Numéro de dépôt international: PCT/EP2008/067289
(87) Numéro de publication internationale: WO 2009/083416

(56) Documents cités:
- WO-A-92/02959
- US-A- 5 502 307
- SETIADI D ET AL: "Application of VDF/TrFE copolymer for pyroelectric image sensors" SENSORS AND ACTUATORS A, vol. 42, no. 1-3, 1994, pages 585-592, XP002487140
- SETIADI D ET AL: "Realization of an integrated VDF/TrFE copolymer-on-silicon pyroelectric sensor" MICROELECTRONIC ENGINEERING, vol. 29, no. 1-4, 1995, pages 85-88, XP004000117

## Description

L'invention concerne la fabrication de circuits électroniques intégrés utilisant une couche ferroélectrique polymère, tels que des capteurs de grandeurs physiques dont le fonctionnement repose sur les propriétés piézoélectriques ou pyroélectriques de la couche ferroélectrique polymère.

De tels capteurs peuvent être constitués sous forme d'une matrice de détecteurs ferroélectriques élémentaires permettant d'établir une image ou une cartographie de pressions ou de températures appliquées à la surface du capteur. La matrice de détecteurs repose sur un circuit intégré électronique qui recueille individuellement les charges électriques ou variations de charges électriques engendrées par chaque détecteur élémentaire, de manière à pouvoir transmettre en sortie du capteur un ensemble de signaux électriques représentant l'image détaillée du champ de températures ou de pressions appliquées à l'ensemble de la matrice. Ils sont applicables par exemple pour de l'imagerie ultrasonique, ou encore pour la détection d'empreintes digitales.

Pour fabriquer ce type de capteurs, on procède en deux phases : dans une première phase on réalise un circuit intégré de technologie courante, par exemple une technologie CMOS, technologie qui a l'avantage de consommer peu de puissance et d'être très largement utilisée avec des procédés de fabrication bien maîtrisés. Et dans une deuxième phase, appelée phase de "post-process" on dépose et on grave les couches nécessaires pour constituer la matrice de détecteurs ferroélectriques élémentaires, c'est-à-dire au moins une première couche conductrice formant des électrodes élémentaires individuelles reliées au circuit intégré sous-jacent, une couche de matériau ferroélectrique, et une deuxième couche conductrice formant une contre électrode pour l'ensemble de la matrice. Les détecteurs élémentaires sont en effet essentiellement constitués par des capacités individuelles dont la couche ferroélectrique constitue un diélectrique sensible à la pression ou la température.

Autant la technologie des circuits intégrés est très bien maitrisée aujourd'hui, autant la technologie de la phase de post-process est délicate à maîtriser. En effet, les couches ferroélectriques connues sont soit des matériaux céramiques ayant de très bonnes propriétés de pyroélectricité ou piézoélectricité, mais coûteux à mettre en oeuvre et mal adaptés à des dépôts sur des circuits intégrés, soit des couches de polymères cristallins, beaucoup moins chères et plus simples à mettre en oeuvre mais ayant de moins bonnes propriétés de pyroélectricité ou piézoélectricité.

Les développements techniques dans la recherche de polymères cristallins ayant les meilleurs coefficients pyro ou piézoélectriques possibles et déposables en couche mince plane ont abouti à mettre au point un copolymère qui est satisfaisant de ce point de vue et qui est le poly(di-fluorure de vinylidène - trifluoroéthylène), abrégé sous la forme P(VDF-TrFE). La proportion de trifluoroéthylène est d'environ 20% à 35% dans le co-polymère, le reste est le di-fluorure de vinylidène. Le composé véritablement pyroélectrique ou piézoélectrique est le poly-di-fluorure de vinylidène (PVDF), qui est de nature cristalline. Le tri-flluroéthylène est là pour empêcher le di-fluorure de vinylidène de se polymériser sous forme de chaînes hélicoïdales qui ne seraient pas adaptées à l'usage qu'on veut en faire. Pour atteindre cet effet de prévention de rotation hélicoïdale, il faut un pourcentage relativement important de trifluroéthylène mélangé intimement au di-fluorure de vinylidène, sans pour autant détériorer les propriétés cristallines et ferroélectriques du PVDF, c'est-à-dire sa capacité à se polariser électriquement ; 20% à 35% de trifluoroéthylène est un chiffre raisonnable de ce point de vue.

Malheureusement, la présence de cette quantité importante de trifluoroéthylène dans le co-polymère s'avère gênante en ce sens qu'elle réduit beaucoup l'adhérence de la couche de co-polymère sur le circuit intégré. Les rendements de fabrication chutent donc et la durée de vie des capteurs également.

Pour pallier cet inconvénient, on a déjà proposé d'interposer entre la couche de P(VDF-TrFE) et le circuit intégré une couche de polyimide, ou, mieux encore, une couche de résine collante telle que du polymétacrylate de méthyl (PMMA en abrégé). Cette couche, par exemple d'un micromètre d'épaisseur, était photogravée, après quoi la première couche conductrice (électrodes de capacités élémentaires) était déposée puis gravée ; le P(VDF-TrFE) était alors déposé, en couche de 1 à 10 micromètres d'épaisseur,

L'ensemble de ces opérations comprenait quatre ou plus souvent cinq opérations de photogravure. En utilisant une sous-couche de PMMA mélangée de composants photosensibles, on pouvait graver directement cette sous-couche sans avoir à déposer d'abord une résine photosensible. Mais l'ensemble restait coûteux en termes de nombre d'opérations de fabrication pour la phase de réalisation des détecteurs sensibles.

De plus, certaines zones périphériques de P(VDF-TrFE) se trouvaient nécessairement en contact direct avec le circuit intégré, sans couche intermédiaire de PMMA. Ces zones où la couche de P(VDF-TrFE) était en contact direct avec le circuit intégré sous-jacent étaient limitées en surface, mais elles constituaient des zones de fragilité et de décollement possible de la couche de P(VDF-TrFE), réduisant les rendements de fabrication et la durée de vie des produits.

Par ailleurs, cette couche de PMMA pouvait facilement être détériorée dans les étapes de gravure des électrodes, notamment dans les phases d'élimination de résine photosensible après gravure du métal, ce qui obligeait à utiliser des procédés de gravure non standard pour ces électrodes.

C'est pourquoi on propose selon l'invention un nouveau procédé qui réduit globalement les inconvénients de la technique antérieure et qui permet notamment de minimiser le nombre d'étapes du processus postérieur à la fabrication du circuit-intégré sous-jacent, tout en améliorant les rendements de production et la durée de vie des produits.

On notera qu'on a proposé dans l'art antérieur une solution alternative qui est un traitement préalable des électrodes pour augmenter l'adhérence du copolymère : article de Setiadi D et al "Application of VDF/TrFE copolymer for pyroelectric image sensors", SENSORS AND ACTUATORS vol. 42, n°1-3, 1994, pages 585-592 (XP002487140).

Le procédé selon l'invention est un procédé de fabrication d'un capteur matriciel utilisant une couche sensible d'un co-polymère ferroélectrique P(VDF-TrFE) déposée sur un circuit intégré, caractérisé en ce qu'il comprend la succession d'étapes suivantes :
- dépôt sur le circuit intégré d'une première couche conductrice et gravure de cette couche pour former un réseau matriciel d'électrodes électriquement reliées au circuit intégré ;
- dépôt d'un co-polymère P(VDF-TrFE) dissous dans un solvant ainsi qu'une petite proportion inférieure à 10%, de préférence entre 1 à 10%, d'un deuxième polymère favorisant l'adhérence du co-polymère P(VDF-TrFE) sur le circuit intégré, et séchage à chaud pour cristalliser le co-polymère ;

- une seule étape de photogravure de la couche de co-polymère P(VDF-TrFE) cristallisée, éliminant le co-polymère et le deuxième polymère dans les régions où le co-polymère ne doit pas être conservé ;
- dépôt d'une deuxième couche conductrice et gravure de cette couche pour former une contre-électrode pour l'ensemble du réseau matriciel.

La petite proportion du deuxième polymère favorisant l'adhérence est :
- soit constituée par une fine couche de deuxième polymère intercalée entre le circuit intégré et le co-polymère P(VDF-TrFE), cette fine couche ayant une hauteur inférieure à 10% de la hauteur de la couche de P(VDF-TrFE), typiquement 0,1 à 0,2 micromètres d'épaisseur pour une hauteur de 2 micromètres du P(VDF-TrFE) ; la hauteur est définie après séchage du co-polymère et du deuxième polymère ;
- soit mélangée intimement au co-polymère P(VDF-TrFE) en proportion massique comprise entre 0,5% et 5%, de préférence environ 1%.

Le deuxième polymère promoteur d'adhérence est, comme on le verra, un polymère de nature amorphe et non cristalline, ce qui est a priori contradictoire avec l'idée de l'intercaler entre les électrodes inférieures et le co-polymère cristallin et contradictoire avec l'idée de le mélanger au co-polymère cristallin, mais la proportion de ce deuxième polymère est suffisamment faible, que ce soit en termes de rapport de hauteurs de couche ou en termes de proportion dans le mélange, pour ne pas détériorer significativement les propriétés de sensibilité à la pression ou à la température des éléments de capteur ainsi fabriqués.

Le deuxième polymère est de préférence du poly-métacrylate de méthyl (PMMA), ou encore un polymère ayant des propriétés similaires vendu par la société Fujifilm sous la dénomination CT4000. Le solvant de ces polymères, pour le dépôt en couche mince est en pratique du Polypropylene Glycol Monomethyl Ether Acetate ou du Ethyl-3-Ethoxy Propionate. Le CT4000 est la substance préférée dans le cas où le deuxième polymère est déposé préalablement au dépôt de P(VDF-TrFE).

Les électrodes sont de préférence en titane. Les plots de contact du capteur, pour la connexion avec l'extérieur, sont de préférence en aluminium (ils sont formés lors de la fabrication du circuit intégré mais doivent être mis à nu à la fin des étapes de post-process).

La gravure du titane est de préférence une gravure par plasma et le plasma utilisé peut être un mélange BCl₃/SF₆ ou SF₆ ou SF₆/O₂. Une telle gravure est plus précise qu'une gravure chimique par voie humide.

La gravure du P(VDF-TrFE), et la gravure simultanée du polymère promoteur d'adhérence, est faite de préférence par plasma d'oxygène et de fluor.

Outre le procédé qui vient d'être résumé, l'invention concerne aussi un capteur comportant une matrice de détecteurs sensibles à la pression ou la température, déposée sur un circuit intégré électronique, dans lequel chaque détecteur est constitué par une capacité formée par une première électrode conductrice, une deuxième électrode conductrice, et une couche ferroélectrique de co-polymère P(VDF-TrFE) entre les électrodes, caractérisé en ce que la couche ferroélectrique comporte un deuxième polymère promoteur d'adhérence en proportion inférieure à 10%, de préférence du poly-métacrylate de méthyl, déposé sous le co-polymère ou mélangé à ce dernier.

D'autres caractéristiques et avantages de l'invention apparaîtront à la lecture de la description détaillée qui suit et qui est faite en référence aux dessins annexés dans lesquels :
- les figures 1 (1 a à 1 c) et 2 (2a à 2d) représentent les étapes successives de formation des capacités élémentaires ferroélectriques dans le procédé de l'art antérieur ;
- la figure 3 (3a à 3e) représente les étapes successives correspondantes du procédé selon l'invention.

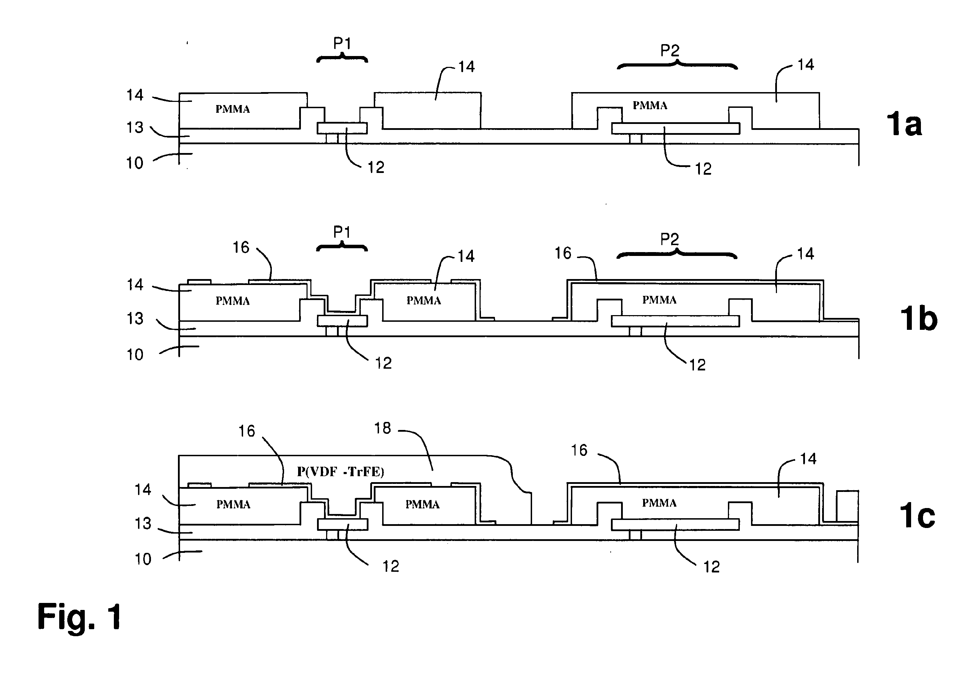

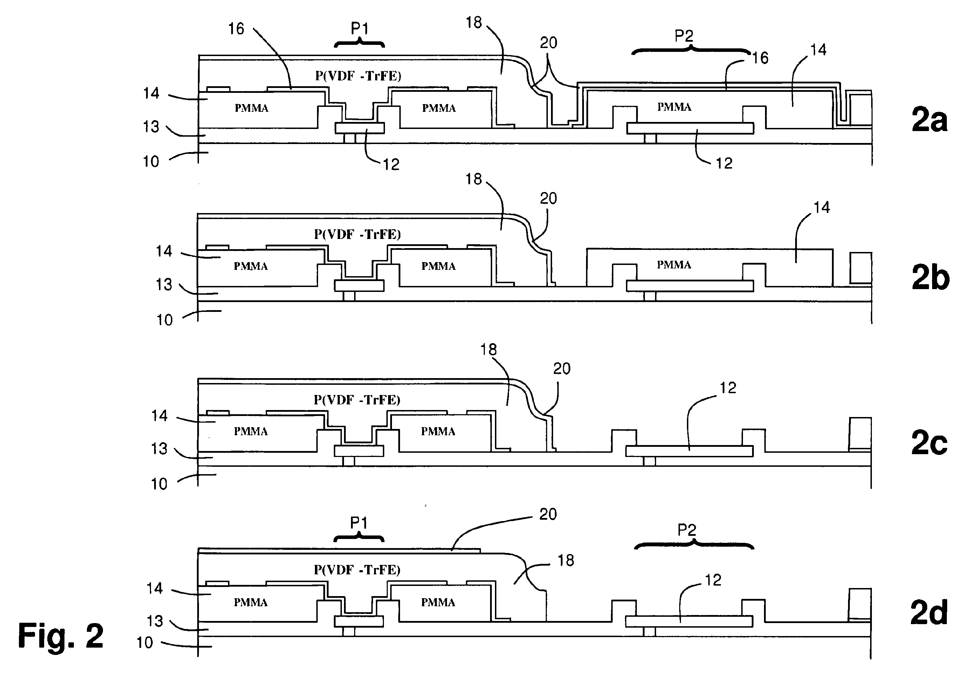

Le procédé de fabrication de l'art antérieur est rappelé en référence aux figures 1 et 2 pour mieux faire comprendre les avantages de l'invention. Seules les étapes dites de "post-process" sont représentées, c'est-à-dire les étapes postérieures à la fabrication du circuit intégré qui sert à recueillir et à traiter les charges engendrées sur les capacités élémentaires qui seront formées dans ces étapes de post-process. Le circuit intégré est de préférence réalisé en technologie CMOS. Le circuit n'est représenté que symboliquement sous forme d'un substrat 10 comportant un dernier niveau de métallisation 12, par exemple une couche d'aluminium, relié électriquement aux couches sous-jacentes du circuit intégré, et un dernier niveau de passivation isolant 13, par exemple en oxyde de silicium ou nitrure de silicium.

La couche de passivation 13 est localement ouverte pour laisser à nu le métal 12 dans des régions P1 où on désire réaliser un contact entre le circuit intégré et les éléments sensibles capacitifs formés dans le post-process, ainsi que dans des régions P2 réservées à la réalisation de plots pour la connexion extérieure. Sur toutes les figures, la partie gauche permet de comprendre comment on réalise les éléments sensibles capacitifs, alors que la partie droite permet de comprendre comment on réalise en même temps les plots de connexion.

La première étape du post-process dans l'art antérieur est une étape de dépôt d'une couche 14 de PMMA (polymétacrylate de méthyl) ; cette couche 14 a une épaisseur d'environ 1 micromètre. Par dépôt d'une couche de PMMA, on entend d'une manière générale les deux phases suivantes :
- le dépôt à la tournette d'une couche du polymère dissous dans un solvant ou le dépôt d'une couche de monomères précurseurs du PMMA dissous dans un solvant ;
- et l'étape de polymérisation qui suit, en général une étape de traitement thermique consistant par exemple à évaporer le solvant et à le recuire.

En pratique, le PMMA est sous forme de métacrylate de méthyl dissous dans du Polypropylène Glycol Monométhyl Ether Acetate et/ou dans de l'acétate de 1-Ethoxy-2-Propanol ; ces solvants s'évaporent à une température d'environ 150°C.

Ensuite, on grave la couche polymérisée 14, pour éliminer le PMMA dans les régions P1, mettant à nu la couche d'aluminium 12 dans ces régions. Le PMMA est conservé dans les régions P2 (sous forme d'îlots de PMMA qui recouvrent entièrement ces régions) et la couche 12 reste protégée dans ces régions (figure 1 a). Cette protection des plots dénudés 12 est nécessaire en raison des étapes de gravure ultérieures qui pourraient détériorer l'aluminium. La gravure de la couche de PMMA est faite par un procédé photolithographique, et de préférence en prévoyant que la couche de PMMA contient des adjuvants qui rendent cette couche photosensible. Ceci évite d'avoir à déposer une résine photosensible sur la couche de PMMA, puis à insoler la résine, puis la développer, puis attaquer la couche de PMMA avec un produit d'attaque qui n'attaque pas la résine, puis à éliminer la couche de résine résiduelle. En rendant la couche de PMMA photosensible on se contente d'insoler la couche, de la développer, et de l'attaquer avec un produit qui attaque sélectivement uniquement les parties insolées ou inversement uniquement les parties non insolées.

L'étape suivante du post-process consiste à déposer une première couche conductrice 16, de préférence du titane, au-dessus du motif gravé de PMMA. Cette couche de titane vient en contact avec la couche d'aluminium 12 dans les régions P1 qui sont à nu, mais pas dans les régions P2 qui sont recouvertes par le PMMA volontairement laissé en place à l'étape précédente.

On grave ensuite la couche de titane 16. C'est une gravure chimique (ou gravure "humide") ; on ne pourrait pas faire une gravure par plasma (ou "gravure sèche") car le PMMA n'y résisterait pas, ou plus précisément ne résisterait pas à l'étape d'enlèvement des résidus de résine photosensible durcie par l'attaque plasma après la gravure du titane. On définit le motif par photolithographie classique. Ce motif est notamment celui des électrodes individuelles du réseau de capacités dont le diélectrique sera la couche de P(VDF-TrFE) ultérieurement déposée. On notera qu'on conserve provisoirement la couche de titane au-dessus de la totalité des îlots de PMMA qui recouvrent les régions P2, afin de protéger le PMMA lors de la gravure ultérieure du P(VDF-TrFE). Cette protection est nécessaire pour ne pas mettre indirectement à nu l'aluminium des régions P2 du fait d'une détérioration du PMMA. Figure 1 b.

On notera que la gravure humide du titane, dans un bain composé typiquement d'une solution d'ammoniaque et de péroxyde d'hydrogène (NH₄OH, H₂O₂), doit se terminer par une étape de retrait des résidus de résine photosensible qui ont servi à définir le motif de titane à conserver. Cette étape se fait par voie humide avec des produits spécifiques non standards car les composés standards attaqueraient le PMMA qui est à nu partout où le titane a été enlevé. Le produit d'enlèvement des résidus de résine est ici un composé d'alcool et d'acétone (produit non standard pour la définition d'un motif de titane).

On dépose ensuite une couche polymère ferroélectrique cristalline 18 constituée de P(VDF-TrFE). On dépose le co-polymère dissous dans un solvant ; le dépôt est fait à la tournette et on effectue un séchage à environ 80°C et un recuit de cristallisation à une température supérieure à la température de fusion (147°C) du P(VDF-TrFE). La couche de co-polymère fait entre 1 et 5 micromètres d'épaisseur.

On grave par photolithographie la couche 18 de P(VDF-TrFE). L'enlèvement du P(VDF-TrFE) ne pose pas de problème particulier, la couche de PMMA étant protégée par le titane au-dessus des régions de plot P2. La gravure est une gravure par plasma d'oxygène et de fluor. Figure 1 c.

Les étapes suivantes du procédé de l'art antérieur sont représentées à la figure 2.

On dépose une deuxième couche conductrice 20, qui est destinée notamment à former la contre-électrode commune du réseau de capacités ferroélectriques. Figure 2a.

Cette contre-électrode est déposée sur toute la surface de la matrice de capacités et chaque capacité élémentaire (constituant un détecteur élémentaire sensible à la pression ou à la température) est formée par une première électrode qui est une portion de la première couche conductrice 16, et une deuxième électrode qui est une portion de la deuxième couche conductrice 20, avec la couche diélectrique de P(VDF-TrFE) 18 entre ces électrodes. Les portions de couche 16 sont isolées les unes des autres et elles sont individuellement en contact avec le circuit intégré sous-jacent par l'intermédiaire de portions de couches d'aluminium 12 sous-jacentes.

La deuxième couche conductrice 20 est de préférence en titane. Elle est gravée en plusieurs étapes pour définir le motif final de contre-électrode.
- on grave d'abord par voie humide le titane après une étape de dépôt, exposition et développement d'une résine de photolithographie masquant la matrice de capteurs et découvrant les régions P2 destinées aux plots de connexion ; on élimine donc le titane seulement au-dessus des régions P2 mais on le conserve partout où il y a du P(VDF-TrFE) ; dans cette étape, on élimine non seulement la deuxième couche conductrice 20 mais aussi la première couche conductrice 16 là où elle ne servait qu'à protéger les îlots de PMMA pendant la gravure du P(VDF-TrFE) ; figure 2b ;
- puis on effectue une attaque au plasma pour enlever les résidus de résine et la couche de PMMA ainsi dénudée ; les plots d'aluminium des régions P2 sont ainsi dénudés ; figure 2c ;
- puis on refait une étape de photolithographie à l'aide d'une résine photosensible pour protéger le titane de la couche 20 là où il doit subsister dans la matrice (et pour protéger les plots d'aluminium des régions P2 lors de la gravure qui suit), et on fait une gravure par voie humide pour éliminer le titane là où il doit être enlevé ; figure 2d ; on notera qu'une gravure humide du titane est nécessaire car une gravure sèche au plasma tend à durcir les résines photosensibles qui recouvrent le motif à protéger, et l'élimination des résidus de résine ainsi durcis risquerait de détériorer, et notamment de décoller, la couche de P(VDF-TrFE) qui a été dénudée par l'enlèvement du titane.

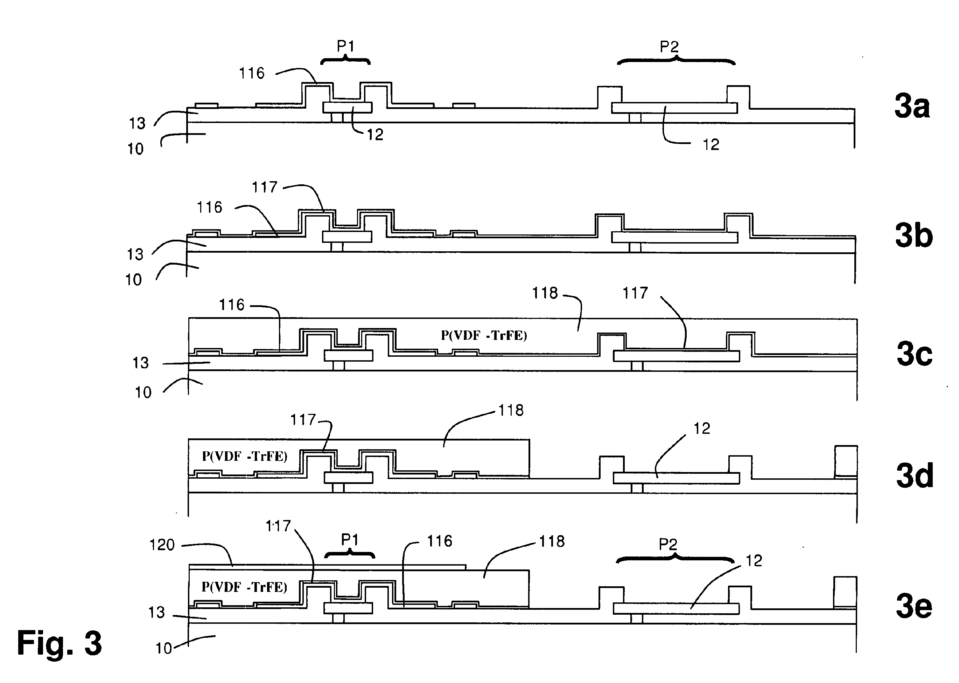

Pour simplifier beaucoup la fabrication, et améliorer les rendements de fabrication et la durée de vie des produits fabriqués, on propose le procédé décrit maintenant en référence à la figure 3.

On part du même substrat de circuit intégré que dans le cas précédent et on va décrire les étapes de "post-process" effectuées sur un circuit intégré qui est de préférence réalisé en technologie CMOS. Le circuit est là encore représenté sous forme d'un substrat 10 comportant un dernier niveau de métallisation 12, par exemple une couche d'aluminium, relié aux couches sous-jacentes du circuit intégré, et un dernier niveau de passivation isolant 13, par exemple en oxyde de silicium ou nitrure de silicium.

La couche de passivation 13 est localement ouverte pour laisser à nu le métal 12 dans des régions P1 où on désire réaliser un contact entre le circuit intégré et les éléments sensibles capacitifs formés dans le post-process, ainsi que dans des régions P2 réservées à la réalisation de plots pour la connexion extérieure. Ici encore, la partie gauche de la figure 3 permet de comprendre comment on réalise les éléments sensibles capacitifs, alors que la partie droite permet de comprendre comment on réalise en même temps les plots de connexion.

La première étape du post-process comprend maintenant directement le dépôt d'une première couche conductrice 116, de préférence du titane, qui vient en contact avec la couche d'aluminium 12 là où elle est à nu. Il n'y a donc pas de dépôt de PMMA avant le dépôt de la première couche conductrice.

On grave ensuite cette couche de titane 116. C'est une gravure sèche, qui est plus standard, plus précise, et mieux maîtrisée que la gravure chimique en ce qui concerne le titane. On définit le motif par photolithographie classique avec une résine résistant à une gravure plasma. La gravure par plasma de BCl₃/SF₆ (ou SF₆ ou SF₆/O₂) dure par exemple une minute (pour 0,2 micromètre d'épaisseur de titane) et est suivie d'une étape d'élimination des résidus de résine photolithographique, par plasma de vapeur d'eau et composé azoté. Ces étapes ne risquent pas de détériorer de couches sous-jacente de PMMA puisqu'il n'y en a pas. Le motif gravé est notamment celui des électrodes individuelles du réseau de capacités dont le diélectrique sera la couche de P(VDF-TrFE) ultérieurement déposée. Figure 3a.

On ne conserve pas le titane au-dessus des régions P2, de sorte qu'il ne sera pas nécessaire de graver une double épaisseur de titane comme c'était le cas à la figure 2a.

La suite du procédé est un dépôt d'une couche ferroélectrique qui sera constituée non seulement de P(VDF-TrFE) mais aussi d'un deuxième polymère qui est un promoteur d'adhérence, c'est-à-dire un polymère permettant de mieux accrocher le P(VDF-TrFE) sur les surfaces sous-jacentes qui sont soit du titane (ou même de l'aluminium) soit la couche de passivation 13. Deux manières de déposer le PVDF-TrFE et le promoteur d'adhérence peuvent être employées :
- selon la première manière, le dépôt se fait en deux étapes, on dépose d'abord une fine couche du deuxième polymère promoteur d'adhérence, sur une faible hauteur, de préférence comprise entre 1 et 10% de la hauteur de la couche ultérieurement déposée de P(VDF-TrFE), par exemple 0,1 micromètre pour 2 micromètres de P(VDF-TrFE) ; on évapore le solvant du promoteur d'adhérence et on le recuit à une température d'environ 240°C qui optimise les propriétés d'adhérence ; et on dépose ensuite le co-polymère P(VDF-TrFE) dissous dans un solvant ; on évapore le solvant du P(VDF-TrFE) et on le recuit à une température supérieure à 150°C (de préférence environ 170°C) pour obtenir une bonne cristallisation ;
- selon la deuxième manière, le dépôt est fait en une seule étape, on dépose un mélange intime des précurseurs du P(VDF-TrFE) et du deuxième polymère promoteur d'adhérence ; le deuxième polymère est de préférence en quantité comprise entre 0,5% et 5% du mélange en masse ; on évapore le solvant et on effectue un recuit de cristallisation à une température supérieure à 150°C (de préférence environ 170°C) ;

Dans les deux hypothèses, les polymères en solution sont déposés à la tournette et on effectue la cristallisation du P(VDF-TrFE) par chauffage ; une température de 170°C convient en général pour cette opération.

Sur la figure 3, on a considéré qu'il y avait un dépôt de polymères en deux étapes, et la figure 3b représente la fine couche 117 du deuxième polymère, promoteur d'adhérence. Ce polymère peut être notamment du PMMA, mais il est déposé en couche beaucoup plus mince que dans l'art antérieur (typiquement environ 0,1 à 0,2 micromètre d'épaisseur au lieu d'environ 1 micromètre ou plus). Le deuxième polymère, promoteur d'adhérence, peut aussi être un polymère ayant des propriétés similaires à celles du PMMA, tel que le CT4000 vendu par la société Fujifilm. Ces deux produits sont très adhérents sur le titane de la couche 116 et sur la couche de passivation 13, et aussi sur l'aluminium.

Il faut souligner ici que le deuxième polymère ne fera pas l'objet d'une étape de gravure indépendante de la gravure du P(VDF-TrFE), que le dépôt ait été fait en deux étapes ou en une étape. En particulier, outre le fait qu'on évite une gravure, on peut remarquer aussi que ce deuxième polymère n'a pas besoin de comporter des additifs qui le rendraient photosensible.

Si le polymère promoteur d'adhérence a été déposé préalablement au P(VDF-TrFE), comme cela est représenté à la figure 3b, on procède alors au dépôt et à la cristallisation d'une couche 118 de P(VDF-TrFE). Figure3c.

S'il n'a pas été déposé préalablement, on dépose un mélange de P(VDF-TrFE) et du deuxième polymère, et on sèche l'ensemble par traitement thermique pour aboutir à une couche 118 unique (pas de couche 117) qui est un mélange cristallin des deux polymères.

On grave alors le P(VDF-TrFE) pour l'éliminer notamment au-dessus des régions de plots P2 et le laisser subsister notamment là où il faut former un réseau de capacités. Le motif est défini par voie photolithographique et l'attaque est faite de préférence par un plasma d'oxygène et de fluor. Cette attaque par plasma enlève également la couche de polymère promoteur d'adhérence, que celui-ci ait été déposé séparément ou en mélange avec la couche de P(VDF-TrFE). Le co-polymère et le polymère promoteur d'adhérence subsistent à l'endroit de la matrice de détecteurs sensibles et disparaissent à l'endroit des régions P2, ce qui dénude l'aluminium dans ces régions. Figure 3d.

Il y a donc une seule étape de photogravure pour définir le motif de P(VDF-TrFE) et le motif identique du polymère promoteur d'adhérence. Le P(VDF-TrFE) est partout associé au promoteur d'adhérence, que celui-ci soit au-dessous ou mélangé.

On dépose ensuite une deuxième couche conductrice 120 qui peut être, comme la première, en titane. Cette couche est destinée notamment à former la contre-électrode commune du réseau de capacités ferroélectriques selon la même configuration que dans le cas de la figure 2.

Enfin, on grave la deuxième couche conductrice 120. Le motif de gravure est défini par photolithographie. Il comprend le motif de contre-électrode à conserver. L'attaque du titane est faite par plasma comme la première couche. Figure3e.

Seuls les bords périphériques de la couche de P(VDF-TrFE) risquent d'être un peu détériorés en fin d'attaque du titane par plasma si la résine de photolithographie a été trop largement consommée pendant cette photogravure. Contrairement au cas de la gravure de la première couche conductrice, l'élimination des résidus de résine se fait par voie humide plutôt que par plasma de vapeur d'eau et composé azoté, pour ne pas détériorer la couche de co-polymère ferroélectrique là où elle n'est plus protégée par le titane. Le bain chimique d'élimination des résidus de résine est de préférence un bain d'éthyl-lactate qui ne décolle pas la couche ferroélectrique rendue adhérente grâce au procédé selon l'invention.

Dans cette étape, on élimine la deuxième couche conductrice 20 au-dessus des plots P2 de sorte que l'aluminium de la couche 12 reste à nu en vue d'une soudure de fils de connexion.

En termes de nombres d'opérations de photogravure, il n'y a plus que trois opérations : photogravure de la première couche conductrice 116, photogravure de la couche de P(VDF-TrFE), et photogravure de la deuxième couche conductrice. On supprime d'autres étapes de photogravure ainsi que des opérations supplémentaires telles que l'élimination de couches résiduelles de PMMA au-dessus des plots de connexion. En termes de facilité de mise en oeuvre, on peut utiliser sans inconvénient des modes de gravure plus simples, et notamment des gravures plasma bien maîtrisées, pour les couches conductrices formant les électrodes de capacités. Des essais ont montré l'excellente adhérence des couches ferroélectriques déposées par ce procédé, sans modification notable des caractéristiques diélectriques et ferroélectriques de la couche ou la superposition de couches situées entre les deux niveaux de titane ; ceci malgré le fait que le polymère promoteur d'adhérence est amorphe et qu'on aurait donc naturellement tendance à surtout ne pas l'employer entre deux électrodes d'un détecteur fonctionnant sur le principe de la ferroélectricité.

Dans ce qui précède, on a considéré que l'on déposait une couche conductrice 116 (du titane) dans une première étape du post-process après la fin de la fabrication d'un circuit intégré dont le dernier niveau de métallisation serait la couche métallique 12 servant à la formation des plots d'aluminium. En d'autres mots, on a considéré que le circuit intégré inclut un dernier niveau de métallisation 12 qui ne sert pas à définir le motif d'électrodes individuelles des détecteurs ferroélectriques et c'est seulement la couche 116 qui le définit. On peut cependant prévoir que les étapes de post-process commencent avec le dépôt sur le circuit intégré d'une couche conductrice 12 qui définit à la fois les électrodes individuelles des détecteurs ferroélectriques et les plots de connexion extérieure. On considère dans ce cas que le circuit intégré comprend les couches conductrices situées au-dessous de la couche 12 mais non la couche 12 et que les étapes de post-process commencent avec le dépôt et la gravure de la couche 12 définissant le réseau d'électrodes mais aussi les plots de connexion. Le dépôt et la gravure de la couche conductrice 12 peut dans ce cas être suivi d'une étape de dépôt d'un isolant de passivation et d'une étape d'ouverture de cet isolant au-dessus des plots de connexion et des électrodes du réseau matriciel, avant l'étape de dépôt et séchage du polymère promoteur d'adhérence et du co-polymère P(VDF-TrFE).

## Revendications

1. Procédé de fabrication d'un capteur matriciel utilisant une couche sensible d'un co-polymère ferroélectrique P(VDF-TrFE), déposée sur un circuit intégré (10, 12, 13), **caractérisé en ce qu'**il comprend la succession d'étapes suivantes:
- dépôt sur le circuit intégré d'une première couche conductrice (116) et gravure de cette couche pour former un réseau matriciel d'électrodes électriquement reliées au circuit intégré ;
- dépôt d'un co-polymère P(VDF-TrFE) dissous dans un solvant ainsi qu'une petite proportion inférieure à 10% d'un deuxième polymère favorisant l'adhérence du co-polymère P(VDF-TrFE) sur le circuit intégré, et séchage à chaud pour cristalliser le co-polymère ;
- une seule étape de photogravure de la couche de co-polymère P(VDF-TrFE) cristallisée (118) éliminant le co-polymère et le deuxième polymère dans les régions où le co-polymère ne doit pas être conservé ;
- dépôt d'une deuxième couche conductrice (120) et gravure de cette couche pour former une contre-électrode pour l'ensemble du réseau matriciel.

2. Procédé selon la revendication 1, **caractérisé en ce que** la petite proportion du deuxième polymère favorisant l'adhérence est constituée par une fine couche de deuxième polymère (117) intercalée entre le circuit intégré et le co-polymère P(VDF-TrFE) (118), cette fine couche ayant une hauteur d'environ 2 à 10% de la hauteur de la couche de P(VDF-TrFE)

3. Procédé selon la revendication 2, **caractérisé en ce que** la hauteur de la fine couche de deuxième polymère est de 0,1 à 0,2 micromètres d'épaisseur.

4. Procédé selon la revendication 1, **caractérisé en ce que** la petite proportion du deuxième polymère favorisant l'adhérence est mélangée intimement au co-polymère P(VDF-TrFE) en proportion comprise entre 0,5% et 5%.

5. Procédé selon l'une des revendications 1 à 4, **caractérisé en ce que** le deuxième polymère est du polyméthylmétacrylate (PMMA), ou un polymère ayant des propriétés similaires vendu par la société Fujifilm sous la dénomination CT4000.

6. Procédé selon l'une des revendications 1 à 5, **caractérisé en ce que** les première et deuxième couches conductrices sont en titane, et **en ce que** la gravure du titane est faite par plasma.

7. Procédé selon l'une des revendications 1 à 6, **caractérisé en ce que** la gravure du P(VDF-TrFE) et la gravure simultanée du polymère promoteur d'adhérence est faite par plasma fluoré.

8. Procédé selon la revendication 7, **caractérisé en ce que** la gravure par plasma fluoré du P(VDF-TrFE) est suivie d'une élimination de résidus de résine photolithographique par plasma d'oxygène.

9. Procédé selon l'une des revendications 1 à 8, caractérisé en que la première couche conductrice définit non seulement un réseau matriciel d'électrodes mais aussi des plots de connexion extérieure du capteur.

10. Capteur comportant une matrice de détecteurs sensibles à la pression ou la température, déposée sur un circuit intégré électronique (10, 12, 13), dans lequel chaque détecteur est constitué par une capacité formée par une première électrode conductrice (116), une deuxième électrode conductrice (120), et une couche ferroélectrique de co-polymère P(VDF-TrFE) (118) entre les électrodes, **caractérisé en ce que** la couche ferroélectrique comporte un deuxième polymère promoteur d'adhérence en proportion inférieure à 10%, déposé sous le co-polymère ou mélangé à ce dernier.

## Patentansprüche

1. Verfahren zur Herstellung eines Matrixsensors, der eine auf einem integrierten Schaltkreis (10, 12, 13) abgelagerte sensible Schicht eines ferroelektrischen Copolymers P(VDF-TrFE) verwendet, **dadurch gekennzeichnet, dass** es die Abfolge folgender Schritte umfasst:
- Ablagerung einer ersten leitenden Schicht (116) auf dem integrierten Schaltkreis und Gravur dieser Schicht, um ein Matrixnetzwerk von mit dem integrierten Schaltkreis elektrisch verbundenen Elektroden zu bilden,
- Ablagerang eines in einem Lösungsmittel gelösten Copolymers P(VDF-TrFE) sowie eines kleinen Anteils unter 10 % eines zweiten Polymers, das die Haftung des Copolymers P(VDF-TrFE) auf dem integrierten Schaltkreis fördert, und Wärmetrocknung, um das Copolymer zu kristallisieren,
- wobei ein einziger Fotogravurschritt der kristallisierten Copolymerschicht P(VDF-TrFE) (118) das Copolymer und das zweite Polymer in den Regionen entfernt, in denen das Copolymer nicht bleiben darf,
- Ablagerung einer zweiten leitenden Schicht (120) und Gravur dieser Schicht, um für das gesamte Matrixnetzwerk eine Gegenelektrode zu bilden.

2. Verfähren nach Anspruch 1, **dadurch gekennzeichnet, dass** der kleine Anteil des haftungsfordemden zweiten Polymers aus einer dünnen Schicht eines zweiten Polymers (117) besteht, die sich zwischen dem integrierten Schaltkreis und dem Copolymer P(VDF-TrFE) (118) befindet, wobei diese dünne Schicht eine Höhe von zirka 2 bis 10 % der Höhe der P(VDF-TrFE)-Schicht hat.

3. Verfahren nach Anspruch 2, **dadurch gekennzeichnet, dass** die Höhe der dünnen zweiten Polymerschicht 0,1 bis 0,2 Mikrometer Dicke hat.

4. Verfahren nach Anspruch 1, **dadurch gekennzeichnet, dass** der kleine Anteil des haftungsfördemden zweiten Polymers innig mit dem Copolymer P(VDF-TrFE) in einen Anteil zwischen 0,5 % und 5 % gemischt ist.

5. Verfähren nach einem der Ansprüche 1 bis 4, **dadurch gekennzeichnet, dass** das zweite Polymer Polymethylmetacrylat (PMMA) oder ein Polymer mit ähnlichen Eigenschaften ist, das von der Firma Fujifilm unter der Bezeichnung CT4000 verkauft wird.

6. Verfahren nach einem der Ansprüche 1 bis 5, **dadurch gekennzeichnet, dass** die erste und zweite leitende Schicht aus Titan sind und dass die Titangravur mit Plasma durchgeführt wird.

7. Verfahren nach einem der Ansprüche 1 bis 6, **dadurch gekennzeichnet, dass** die Gravur des P(VDF-TrFE) und die gleichzeitige Gravur des haftungsfördernden Polymers mit Fluoridplasma durchgeführt wird.

8. Verfahren nach Anspruch 7, **dadurch gekennzeichnet, dass** sich an die Gravur mit Fluoridplasma des P(VDF-TrFE) das Entfernen von Rückständen fotolitographischen Harzes durch Sauerstoffplasma anschließt.

9. Verfahren nach einem der Ansprüche 1 bis 8, **dadurch gekennzeichnet, dass** die erste leitende Schicht nicht nur ein Elektroden-Matrixnetzwerk definiert, sondern auch äußere Kontaktklötze des Sensors.

10. Sensor, der eine Matrix druck- oder temperatursensibler Detektoren aufweist, die auf einem elektronischen integrierten Schaltkreis (10, 12, 13) abgelagert ist, wobei jeder Detektor aus einer Kapazität besteht, die von einer ersten leitenden Elektrode (116), einer zweiten leitenden Elektrode (120) und einer ferroelektrische Copolymerschicht P(VDF-TrFE) (118) zwischen den Elektroden gebildet wird, **dadurch gekennzeichnet, dass** die ferroelektrische Schicht ein zweites haftungsfördemdes Polymer in einem Anteil unter 10 % aufweist, die unter dem Copolymer abgelagert oder mit diesem gemischt ist.

## Claims

1. A process for manufacture matrix sensor using a sensitive layer of a ferroelectric P(VDF/TrFE) copolymer, deposited on an integrated circuit (10, 12, 13), **characterized in that** it comprises the succession of the following steps:
- deposition on the integrated circuit of a first conductive layer (116) and etching of this layer in order to form a matrix array of electrodes electrically connected to the integrated circuit;
- deposition of a P(VDF/TrFE) copolymer dissolved in a solvent and also a small proportion of less than 10% of a second polymer that favors the adhesion of the P(VDF/TrFE) copolymer on the integrated circuit, and drying at high temperature in order to crystallize the copolymer;
- a single step of photoetching of the crystalline P(VDF/TrFE) copolymer layer (118) removing the copolymer and the second polymer in the regions where the copolymer should not be retained; and
- deposition of a second conductive layer (120) and etching of this layer in order to form a counter electrode for the whole of the matrix array.

2. The process as claimed in claim 1, **characterized in that** the small proportion of the second polymer favoring adhesion is constituted by a thin layer of second polymer (117) inserted between the integrated circuit and the P(VDF/TrFE) copolymer (118), this thin layer having a height of around 2 to 10% of the height of the P(VDF/TrFE) layer.

3. The process as claimed in claim 2, **characterized in that** the height of the thin layer of second polymer is from 0.1 to 0.2 micrometers in thickness.

4. The process as claimed in claim 1, **characterized in that** the small proportion of the second polymer that favors the adhesion is intimately mixed with the P(VDF/TrFE) copolymer in a proportion between 0.5% and 5%.

5. The process as claimed in one of claims 1 to 4, **characterized in that** the second polymer is polymethyl methacrylate (PMMA) or a polymer having similar properties sold by Fujifilm under the name CT4000.

6. The process as claimed in one of claims 1 to 5, **characterized in that** the first and second conductive layers are made of titanium, and **in that** the etching of the titanium is carried out by plasma etching.

7. The process as claimed in one of claims 1 to 6, **characterized in that** the etching of the P(VDF/TrFE) and the simultaneous etching of the adhesion-promoting polymer is carried out by fluorinated plasma etching.

8. The process as claimed in claim 7, **characterized in that** the fluorinated plasma etching of the P(VDF/TrFE) is followed by a removal of photolithographic resist residues by oxygen plasma.

9. The process as claimed in one of claims 1 to 8, **characterized in that** the first conductive layer defines not only a matrix array of electrodes but also connection pads outside of the sensor.

10. A sensor comprising a matrix of pressure-sensitive or temperature-sensitive detectors, which matrix is deposited on an electronic integrated circuit (10, 12, 13), in which each detector is constituted by a capacitor formed by a first conductive electrode (116), a second conductive electrode (120) and a ferroelectric layer of P(VDF/TrFE) copolymer (118) between the electrodes, **characterized in that** the ferroelectric layer comprises a second adhesion-promoting polymer in a proportion of less than 10%, deposited under the copolymer or blended with the latter.
